(19) Europäisches Patentamt / European Patent Office / Office européen des brevets

(11) **EP 2 362 544 A1**

(12) **EUROPEAN PATENT APPLICATION**

(43) Date of publication:
**31.08.2011 Bulletin 2011/35**

(51) Int Cl.:
***H03G 3/30*** (2006.01)

(21) Application number: **10290090.9**

(22) Date of filing: **23.02.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(71) Applicant: **Alcatel Lucent**
**75008 Paris (FR)**

(72) Inventor: **Martens, Henning**
**71254 Ditzingen (DE)**

(74) Representative: **Richardt Patentanwälte**
**Wilhelmstraße 7**
**65185 Wiesbaden (DE)**

Remarks:
Amended claims in accordance with Rule 137(2) EPC.

(54) **A signal amplifying component with gain compensation stages for compensating gain tolerances**

(57)    The invention relates to a signal-amplifying component (100), the signal-amplifying component comprising a plurality of electronic devices (102-130), the plurality of electronic devices comprising at least one filter (102; 118; 122; 128), at least one mixer (120), at least one gain stage (110; 114; 126), the at least one gain stage comprising at least one transistor, and at least a first (112) and a second (116) gain compensation stage, the at least first and second gain compensation stages being adapted for compensating gain tolerances of the plurality of electronic devices, wherein the gain tolerances of the plurality of electronic devices are compensated by amplifying and/or attenuating the signal with at least a first and a second gain compensation value in the at least two gain compensation stages.

Fig. 1

EP 2 362 544 A1

## Description

## Background and related art

Gain tolerance compensation is important in signal amplifying components because each part of the signal amplifying component has a certain fabrication gain tolerance. Additionally, the response of an electronic device may vary for different frequencies. Also the temperature may influence the gain of an electronic device.

Hence, gain compensation is applied in signal amplifying components such as in EP1418676 A1.

## Summary of the invention

It is the object of the present invention to provide an improved signal amplifying component with at least two gain compensation stages for compensating gain tolerances of electronic devices of the signal amplifying component. This object is achieved by a signal amplifying component according to independent claim 1. Embodiments of the invention are given in the dependent claims.

The invention provides a signal amplifying component comprising a plurality of electronic devices. The plurality of electronic devices may for example be at least one filter, at least one mixer, at least one gain stage, and at least a first and a second gain compensation stage. The at least one gain stage comprises at least one transistor. The at least first and second gain compensation stages are adapted for compensating gain tolerances of the plurality of electronic devices. The gain tolerances of the plurality of electronic devices are compensated by amplifying and/or attenuating the signal with at least a first and a second gain compensation value in the at least two gain compensation stages. The gain tolerances of the electronic devices may for example originate from the manufacturing, a certain frequency dependence of the gain tolerance and/or a temperature dependent gain tolerance. The signal being attenuated and/or amplified is amplified in the signal amplifying component.

It is to be noted that the gain compensation of the gain tolerances of the plurality of electronic devices is performed by at least two digital controlled gain compensation stages. It is advantageous that the gain compensation is not performed in one gain compensation stage, the two gain compensation stages are preferably separated from each other by at least one electronic device such as the at least one mixer, the at least one gain stage, and/or the at least one filter.

Performing the gain compensation in different gain compensation stages in one module distributes the gain compensation over the whole chain of electronic devices. This means that the tolerance is compensated at that place, where it has appeared. The use of at least two gain compensation stages leads to a lower noise figure, especially for high compensations. This is especially advantageous for a receiver chain in a base station of a wireless communication network supporting multiple standards. This leads to a very high supported dynamic range and therefore several stages, also referred to as electronic devices, are necessary in the receiver chain. Every electronic device has an unwanted gain tolerance and/or tolerances are adding themselves. For example, in a chain of about ten electronic devices there may be a compensation range of about 20 dB necessary. For such a high compensation in one gain compensation stage the following stage needs an additional dynamic of 20 dB. The compensation with 20 dB also has an impact to the noise figure.

The at least two compensation stages according to embodiments of the invention are distributed in the receive chain. For example one or two in the radio frequency band, one in the intermediate frequency band and one in the base band.

According to embodiments of the invention the signal amplifying component comprises a computing unit. The computing unit uses a lookup table for determining the at least first and second gain compensation values. The lookup table comprises a plurality of temperature compensation values and/or a plurality of frequency compensation values. The computing unit transmits the first gain compensation value to the first gain compensation stage and the second gain compensation value to the second gain compensation stage.

Therefore, the manufacturing tolerances, the temperature variation tolerances and the frequency response tolerances must be stored in the lookup table. This may be realised for example by calibrating the gain of every module during the fabrication process in the factory and storing the manufacturing tolerances in the lookup table, which is stored in a storage in the signal amplifying component. The frequency response of every module may also be measured during or after the fabrication process and may also be stored in the lookup table. The same applies for the temperature variation of the gain tolerance for every electronic device of the signal amplifying component.

According to embodiments of the invention the signal amplifying component comprises a computing unit. The computing unit calculates a temperature compensation value and/or a frequency compensation value. The computing unit determines the at least first and second gain compensation values from the temperature compensation value and/or from the frequency compensation value. The computing unit may also use the manufacturing gain tolerances of the electronic devices for calculating the first and the second gain compensation values.

Embodiments of the invention are advantageous because the noise figure is lowered, and the linearity in the several electronic devices is lower in comparison to a gain compensation with a single gain compensation stage. Due to the lower required linearity lower power consumption is possible and shop costs can be improved if the signal amplifying component for example is comprised by a receiver. In this case the antenna filter performance can be relaxed and due to possible cheaper components in the analogue signal processing chain shop costs are reduced.

According to embodiments of the invention the electronic devices are cascadedly arranged.

According to embodiments of the invention the computing unit determines the at least first and second gain compensation values by using system parameters, the system parameters being transmitted to the computing unit by external components.

According to embodiments of the invention the system parameters comprise the temperature of the electronic devices, the frequency of the signal, and/or the manufacturing tolerances of the electronic devices. For determining the temperature in a base station comprising a receiver comprising a signal amplifying component according to embodiments of the invention a temperature sensor is already present and only needs to be connected to the signal amplifying component. The frequency of a received and/or transmitted signal is also easy to detect by an external component in a receiver and/or a transmitter. The manufacturing tolerances may for example be stored in the signal amplifying component or in an external component.

According to embodiments of the invention the first gain compensation stage compensates the gain tolerances of a first sub-group of electronic devices of the plurality of electronic devices and the second gain compensation stage compensates the gain tolerances of a second sub-group of electronic devices of the plurality of electronic devices.

In another aspect the invention relates to a receiver for receiving signals. The receiver comprises a signal amplifying component according to embodiments of the invention. This is as already outlined about especially advantageous for receivers supporting a high dynamic range. Such a receiver may for example be present in a base station, wherein the base station supports wireless communication in a wireless communication network according to several standards such as LTE, WCDMA and/or GSM.

In another aspect the invention relates to a transmitter for transmitting signals. The transmitter comprises a signal amplifying component according to embodiments of the invention. For the transmitter the same advantages are achieved as for the receiver.

In yet another aspect the invention relates to a base station apparatus in a mobile telecommunication network. The base station apparatus comprises a receiver according to embodiments of the invention and/or a transmitter according to embodiments of the invention. Such a base station apparatus is especially advantageous for supporting a huge variety of mobile communication standards as already described above.

In yet another aspect the invention relates to a method for compensating gain tolerances in a signal amplifying component according to embodiments of the invention. The method comprises determining at least a first and a second gain compensation value. The first gain compensation value is then used by the first gain compensation stage and the second gain compensation value is used by the second gain compensation stage. The method further comprises compensating the gain tolerances of the plurality of electronic devices by the at least first and second gain compensation stages. The gain compensation stages thereby use the first and the second gain compensation value respectively.

According to embodiments of the invention the method further comprises a step of determining the first and second gain compensation values by using a lookup table. The lookup table comprises a plurality of temperature compensation values and/or a plurality of frequency compensation values.

According to embodiments of the invention the method further comprises determining the first and second gain compensation values by calculating a temperature compensation value and/or a frequency compensation value. The calculation is performed by the computing unit by using a temperature value and/or a frequency value. The temperature value and/or the frequency value may for example be determined by at least one external component.

In yet another aspect the invention relates to a computer readable storage medium containing instructions that when executed by a signal amplifying component according to embodiments of the invention cause the signal amplifying component to perform a method for compensating gain tolerances in the signal amplifying component. The method comprises determining at least a first and a second gain compensation value. The first gain compensation value is used by the first gain compensation stage and the second gain compensation value is used by the second gain compensation stage. The method further comprises compensating the gain tolerances of the plurality of electronic devices by the at least first and second gain compensation stages by using the first and the second gain compensation value respectively.

According to embodiments of the invention the step of controlling the compensation of the gain tolerances of the plurality of electronic devices is performed dependent on temperature of the electronic devices and/or frequency of the signal, temperature of the electronic devices and/or the frequency of the signal is determined by external components.

**Brief description of the drawings**

In the following preferred embodiments of the invention will be described, by way of example only, and with reference to the drawings in which:

Figure 1    is a block diagram of the signal amplifying component in combination with a chart of gain values and noise figures,

Figure 2    is a level diagram comparing two input signal levels being amplified with maximum gain and minimum gain in a signal amplifying component of Fig. 1 with two gain compensation stages,

Figure 3 is a level diagram comparing two input signal levels being amplified with maximum gain and minimum gain in a signal amplifying component with only one analogue compensation stage,

Figure 4 is a level diagram comparing two input signal levels being amplified with maximum gain and minimum gain in a signal amplifying component without any gain compensation stage,

Figure 5 is a block diagram of a base station comprising a receiver and a transmitter, and

Figure 6 is a flow diagram of a method of gain tolerances in a signal amplifying component with two gain compensation stages.

**Detailed description**

Like numbered elements in these Figs. are either identical elements or perform the same function. Elements which have been discussed previously will not necessarily be discussed in later Figs if the function is identical.

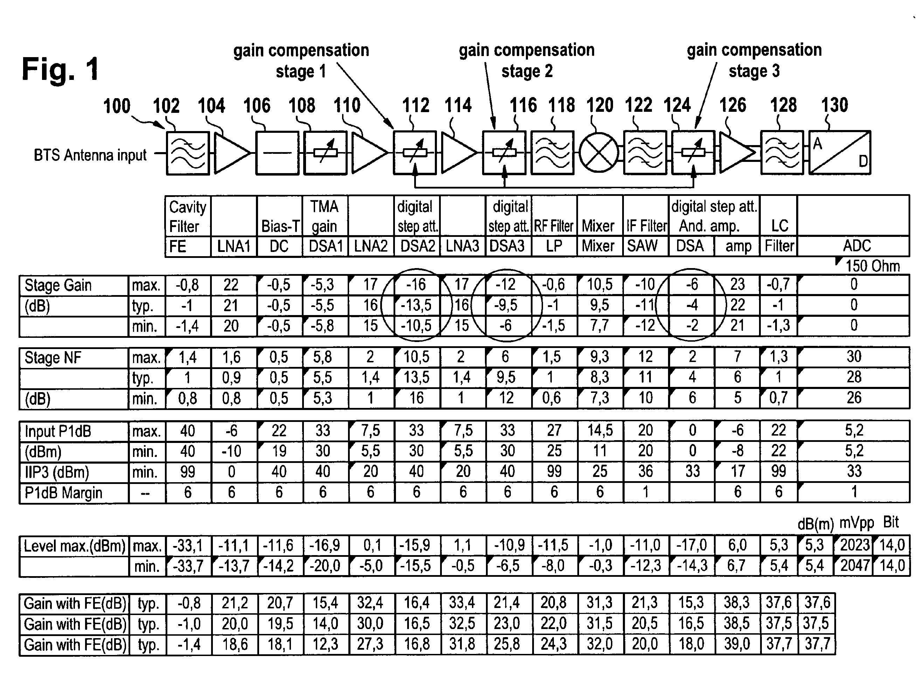

Fig. 1 is a block diagram of a signal amplifying component 100 in combination with a chart. The signal amplifying component 100 comprises a plurality of electronic devices 102-128 and an analogue digital converter 130. For each electronic device 102-128 the chart displays a maximum gain of the electronic device, also referred to as stage, a typical gain of the electronic device, and a minimum gain of the electronic device. The variance in the gain may also be called gain tolerance and originates from temperature differences, different frequency signals, and/or manufacturing tolerances.

The signal is put in at the cavity filter 102, passes every electronic device 104-128 and is converted in the analogue digital converter 130 into a digital signal.

In the last two rows of the chart the added gain is indicated at every stage of the signal amplifying component. The last electronic device contributing to the gain tolerances is the LC filter 128, which is located in the analogue signal chain directly before analogue digital converter 130. The three gain compensation stages 112, 116 and 124 are controlled by a computing unit (not depicted) such that the added gain at the LC filter 128 is equal for the maximum gains of the electronic devices 102-128, the typical gain of the electronic devices 102-128, and the minimum gain of the electronic devices 102-128.

Because this control does not work in practice as perfect as in theory, the added gain values at the LC filter 128 vary slightly for the maximum gain of the electronic devices 102-128 (37.6 dB), for the typical gain of the electronic devices 102-128 (37.5 dB), and for the minimum gain of the electronic devices 102-128 (37.7 dB). The gain compensation stages 112, 116, 124 are adapted for gain compensation in steps of 0.5 dB. This is why the values for different gains, e.g. minimum, typical, and maximum gain, vary by up to $\pm 0.25$ dB. Other gain compensation step sizes are possible. Smaller step sizes would lead automatically to a higher precision in gain compensation.

The gain of the gain compensation stages 116, 124, 112 indicated in the row of the chart corresponding to the maximum gain of the electronic devices is the minimum value of the corresponding gain compensation stage because the gain of the gain compensation stages 112, 116, 124 is decreased by the computing unit for higher gains of the rest of the electronic devices and increased for lower gains of the rest of the electronic devices. Thus, for the minimum gain values of the rest of the electronic devices the gain compensation stages 112, 116, 124 have their highest gain values. As a matter of course the typical gain value of the gain compensation stages 112, 116, 124 lies between the maximum and the minimum value. It is to be noted that the gain compensation values of the gain compensation stages 112, 116, 124 can be adapted by the computing unit continuously between the maximum and the minimum value.

The computing unit knows the minimum, the typical and the maximum gain of the plurality of electronic devices 102-128 for example from a lookup table. Alternatively, the computing unit is provided with formulas for calculating the minimum value, the typical value and the maximum value. It is to be noted that the lookup table of course comprises more than only the three values indicated in the chart of Fig. 1. The more values are stored in the lookup table the more precisely the computing unit can calculate the necessary gain compensation values for the gain compensation stages 112, 116, 124. The formula for calculating the gain compensation values comprises the fixed manufacturing tolerances of each electronic device 102-110, 114, 118-122, 128, a term for considering variances in gains due to temperature variances, and a term for considering different gain values for different signal frequencies. Thus, the formula may for example be:

$$G=kT+cf$$

Wherein g is the total expected gain value, also referred to as the added gain value of the plurality of electronic devices 102-128 except the gain compensation stages 112, 116, 124, T is the temperature and f the signal frequency. k and c are constant values depending on the electronic devices 102-110, 114, 118-122, 126, 128.

k and c may for example be determined by measuring the gain values of every electronic device 102-110, 114, 118-122, 126, 128 for different temperature values and different frequency values. By knowing the response of every electronic device to frequency and temperature variation the constants can be determined. Therefore, the gain tolerances for every electronic device must be measured during the manufacturing process with respect to temperature variations and frequency variations.

Alternatively, the whole chain of electronic devices 102-110, 114, 118-122, 126, 128 is measured during the manufacturing process in one measurement. This approach is much less time-consuming than the above mentioned approach. Then, only the gain values for the whole chain are stored in the lookup table or used for determining the constants k and c. But this does not render the method less precise, because always the whole chain is used for signal processing and not only some elements.

By the same measuring processes as described above the values for the lookup table may be obtained. In operation the temperature value and/or the signal frequency may be provided to the signal amplifying component 100 from external components. For example in a base station, a temperature sensor is already present and/or the frequency of the signal if already known to the base station apparatus.

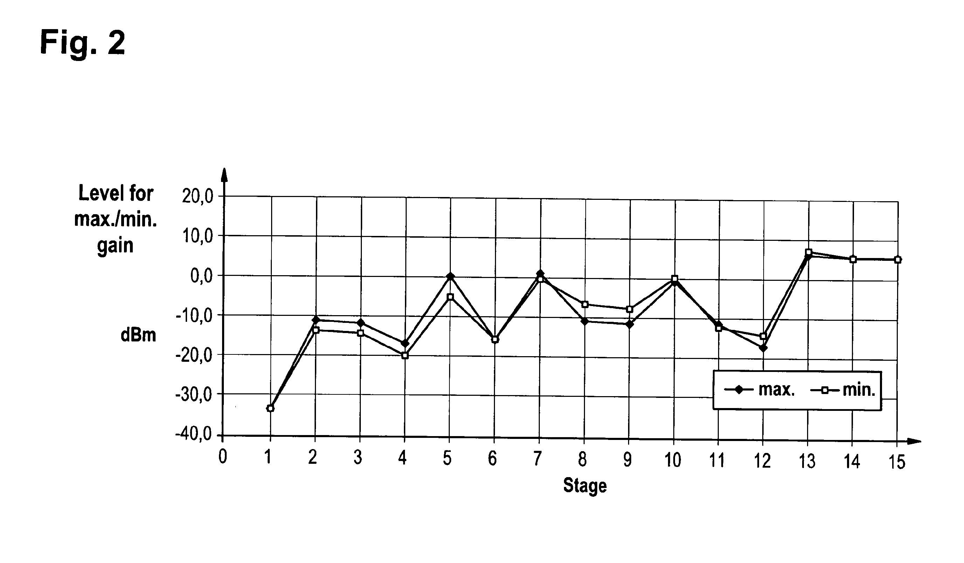

Fig. 2 is a level diagram for a signal amplifying component according to Fig. 1. The y-axis represents the signal level for a first signal amplified by the maximum gain of the electronic devices 102-128, and for a second signal amplified by the minimum gain of the electronic devices 102-128. The x-axis represents the signal path through the signal amplifying component. The signal is input into the cavity filter 128 (x-axis point 1) through the electronic devices 104-128 (x-axis points 2-14) to analogue digital converter 130 (x-axis point 15). The three gain compensation stages 112, 116, 124 are controlled by the computing unit such that the first and the second signal, which are both input at the same signal level of -33 dB, are output at the same signal level of about 5 dB. This shows that the gain compensation tolerances of the plurality of electronic devices are compensated by the gain compensation stages 112, 116, 124.

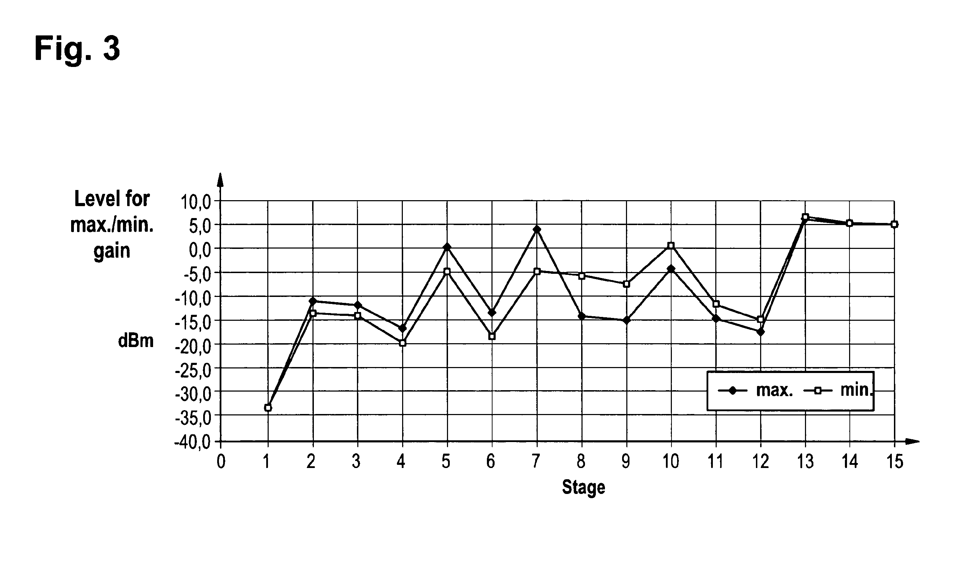

Fig. 3 is a level diagram for a first and a second signal such as in Fig. 2. The difference to Fig. 2 is that only one compensation stage is present in the signal amplifying component 100. Instead of gain compensation stage 112 another electronic device is present in the analogue signal path in signal amplifying component 100. This replacement electronic device has the same values for the minimum and the maximum gain. Thus, this electronic replacement device does not effect the added gain of the plurality of electronic devices 102-128. The same applies for the third gain compensation stage 124. Gain compensation stage 124 is also replaced by such a replacement electronic device. Thus, only the second gain compensation stage 116 is present in the signal amplifying component according to Fig. 2. The gain compensation stage 116 is located at position 8 of the x-axis in Fig. 2.

Because the first gain compensation stage 112 is missing in Fig. 2 the signal level of the first signal is almost 5 dB higher than in Fig. 1 at the third low noise amplifier 114. Low noise amplifier 114 is referred to as stage 7 in Fig. 2 because it is located at the seventh position after the cavity filter 102. This leads to the fact that the low noise amplifier 114 needs nearly 5 dB more linearity with respect to the low noise amplifier 114 in the embodiment of Figs. 1 and 2.

The signal level of the first signal in stages 8 and 9, which correspond to gain compensation stage 114 and RF filters 116 and 118, is nearly 5 dB less than the signal level of the second signal. This fact results in a worse noise figure in comparison to the signal amplifying component of Figs. 1 and 2.

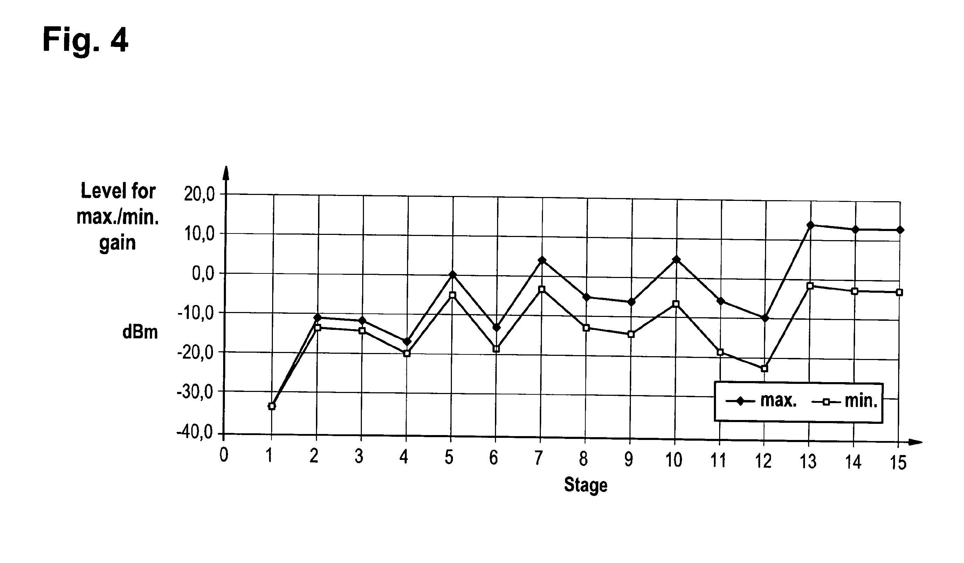

Fig. 4 is a level diagram for a first and a second signal in a signal amplifying component without any gain compensation stage. It is clearly visible that the two signals drift away from each other during signal processing and are both amplified with different added gain values, which differ by about 16 dB. This leads to an unwanted 16 dB residual gain variation at the analogue digital converter input. The noise is significantly higher than in the embodiments of Figs. 2 and 3.

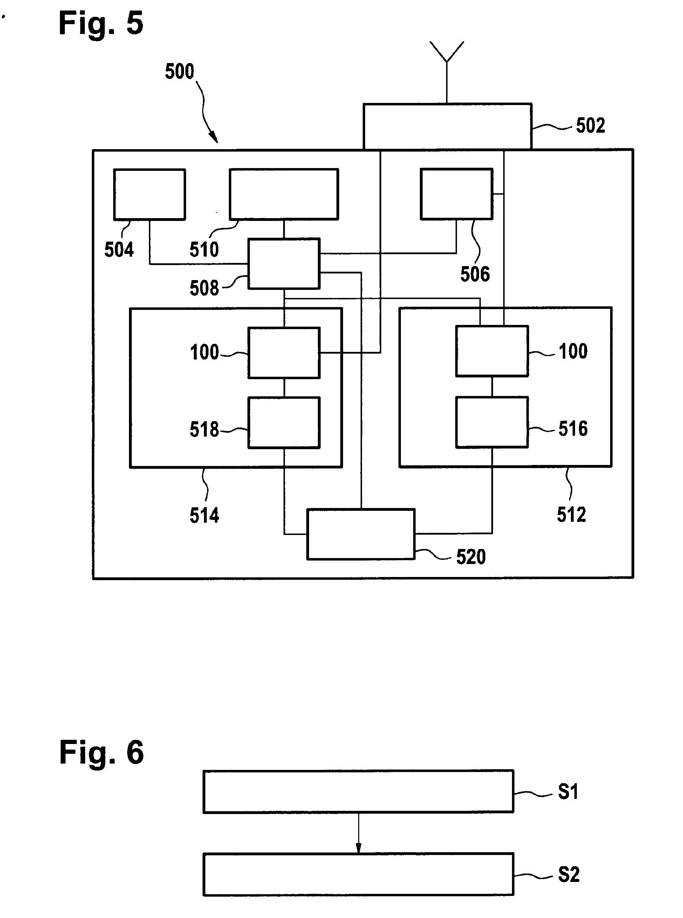

Fig. 5 is a block diagram of a base station 500 according to embodiments of the invention. Base station 500 comprises a signal receiving and transmission means 502, which may for example by an antenna. Further, base station 500 comprises a temperature sensor 504 and a signal frequency determination component 506. The base station 500 further comprises a computing unit 508, a data storage 510, a receiver 512, and a transmitter 514. The receiver and the transmitter each comprise a signal amplifying component 100. The receiver 512 further comprises an output 516, while the transmitter 514 comprises an input 518. Base station 500 further comprises a signal processing circuit 520.

In operation, a signal may be received by antenna 502 and then be forwarded to receiver 512 more specifically to the signal amplifying component 100 in receiver 512. It is to be noted that also other signal processing steps may be performed before forwarding the signal to receiver 512. The frequency of the received signal is determined by frequency determination component 506. The computing unit 508 receives from the frequency determination component 506 the frequency of the received signal. Additionally the computing unit 508 receives from the temperature sensor 504 the measured temperature. From a data storage 510 the computing unit reads the gain compensation tolerances of the electronic devices of signal amplifying component 100 for the measured temperature and the measured signal frequency. Alternatively the computing unit 508 may not calculate the gain tolerances but instead read them from a lookup table stored in data storage 510. In dependence of the calculated gain tolerances the computing unit 508 controls the gain compensation stages in signal amplifying component 100 such that the gain tolerances of the electronic devices are compensated and the signal is put out with a low noise figure, and a constant added gain value to analogue digital converter in signal amplifying component 100. The digital signal is then transmitted to output 516 and forwarded to signal processing circuit 520, where further signal processing may take place.

For a signal to be sent by the base station from the signal processing circuit to for example a user equipment connected to the wireless telecommunication network and served by the base station, the signal to be transmitted is sent from the signal processing circuit to the input 518 of transmitter 514. In transmitter 514 signal amplifying component 100 amplifies the signal and compensates gain tolerances of its electronic devices similar to signal amplifying component 100 in receiver 512. Gain compensation in signal amplifying component 100 in transmitter 514 is also performed by computing unit 508. The signal frequency of the signal to be transmitted is provided to computing unit 508 by signal processing circuit 520.

Fig. 6 is a flowchart of a method for compensating gain tolerances in a signal amplifying component 100. The method comprises step S1: determining at least a first and a second gain compensation value, the first gain compensation value being used by the first gain compensation stage and the second gain compensation value being used by the second gain compensation stage. The method further comprises step S2: compensating the gain tolerances of the plurality of electronic devices by the at least first and second gain compensation stages.

**List of reference numerals**

| 100 | Signal amplifying component |
|-----|------------------------------|
| 102 | Cavity filter |
| 104 | Low noise amplifier |
| 106 | Bias T |
| 108 | TMA attenuation |
| 110 | LNA |
| 112 | Gain compensation stage |
| 114 | LNA |
| 116 | Gain compensation stage |
| 118 | RF filter |
| 120 | Mixer |
| 122 | IF filter |
| 124 | Gain compensation stage |
| 126 | Amplifier |
| 128 | LC filter |

(continued)

| 130 | Analogue digital converter |
|-----|------------------------------|
| 500 | Base station |
| 502 | Antenna |
| 504 | Temperature sensor |
| 506 | Frequency determination component |
| 508 | Computing unit |
| 510 | Data storage |
| 512 | Receiver |
| 514 | Transmitter |
| 516 | Output |
| 518 | Input |
| 520 | Signal processing circuit |

**Claims**

1. A signal-amplifying component (100), the signal-amplifying component comprising a plurality of electronic devices (102-130), the plurality of electronic devices comprising at least one filter (102; 118; 122; 128), at least one mixer (120), at least one gain stage (110; 114; 126), the at least one gain stage comprising at least one transistor, and at least a first (112) and a second (116) gain compensation stage, the at least first and second gain compensation stages being adapted for compensating gain tolerances of the plurality of electronic devices, wherein the gain tolerances of the plurality of electronic devices are compensated by amplifying and/or attenuating the signal with at least a first and a second gain compensation value in the at least two gain compensation stages.

2. Signal-amplifying component according to claim 1, wherein the signal-amplifying component comprises a computing unit (508), the computing unit using a look-up table for determining the at least first and second gain compensation values, the look-up table comprising a plurality of temperature compensation values and/or a plurality of frequency compensation values, and wherein the computing unit transmits the first gain compensation value to the first gain compensation stage and the second gain compensation value to the second gain compensation stage.

3. Signal-amplifying component according to claim 1, wherein the signal-amplifying component comprises a computing unit, the computing unit calculating a temperature compensation value and/or a frequency compensation value, the computing unit determining the at least first and second gain compensation values from the temperature compensation value and/or from the frequency compensation value.

4. Signal-amplifying component according to any one of the preceding claims, wherein the electronic devices are cascadedly arranged.

5. Signal-amplifying component according to any one of the claims 2-4, wherein the computing unit determines the at least first and second gain compensation values by using system parameters, the system parameters being transmitted to the computing unit by external components.

6. Signal-amplifying component according to claim 5, wherein the system parameters comprise the temperature of the electronic devices, the frequency of the signal, and/or the manufacturing tolerances of the electronic devices.

7. Signal-amplifying component according to any one of the preceding claims, wherein the first gain compensation stage compensates the gain tolerances of a first subgroup of electronic devices of the plurality of electronic devices, and wherein the second gain compensation stage compensates the gain tolerances of a second subgroup of electronic devices of the plurality of electronic devices.

8. A receiver (512) for receiving signals, the receiver comprising a signal-amplifying component according to any one of the claims 1-7.

9. A transmitter (514) for transmitting signals, the transmitter comprising a signal-amplifying component according to any one of the claims 1-7.

10. A base station apparatus (500) in a mobile telecommunication network, the base station apparatus comprising a receiver according to claim 8 and/or a transmitter according to claim 9.

11. A method for compensating gain tolerances in a signal-amplifying component according to any one of the claims 1-7, the method comprising:

    - Determining (S1) at least a first and a second gain compensation value, the first gain compensation value being used by the first gain compensation stage and the second gain compensation value being used by the second gain compensation stage; and
    - Compensating (S2) the gain tolerances of the plurality of electronic devices by the at least first and second gain compensation stages.

12. Method according to claim 11, wherein the step of determining the first and second gain compensation values is performed by using a look-up table, the look-up table comprising a plurality of temperature compensation values and/or a plurality of frequency compensation values.

13. Method according to claim 11, wherein the step of determining the first and second gain compensation values is performed by calculating a temperature compensation value and/or a frequency compensation value, the calculation being performed by the computing unit by using a temperature value and/or a frequency value, the temperature value and/or the frequency value being determined by at least one external component.

14. A computer-readable storage medium containing instructions that when executed by a signal-amplifying component according to any one of the claims 1-7 cause the signal-amplifying component to perform a method for compensating gain tolerances in the signal-amplifying component, the method comprising:

    - determining at least a first and a second gain compensation value, the first gain compensation value being used by the first gain compensation stage and the second gain compensation value being used by the second gain compensation stage; and
    - compensating the gain tolerances of the plurality of electronic devices by the at least first and second gain compensation stages.

15. Computer-readable storage medium according to claim 14, wherein the step of controlling the compensation of the gain tolerances of the plurality of electronic devices is performed dependent on temperature of the electronic devices, and/or frequency of the signal, the temperature of the electronic devices and/or the frequency of the signal being determined by external components.

**Amended claims in accordance with Rule 137(2) EPC.**

1. A signal-amplifying component (100), the signal-amplifying component comprising a plurality of electronic devices (102-130), the plurality of electronic devices comprising at least one filter (102; 118; 122; 128), at least one mixer (120), at least one gain stage (110; 114; 126), the at least one gain stage comprising at least one transistor, and at least a first (112) and a second (116) gain compensation stage, the at least first and second gain compensation stages being adapted for compensating gain tolerances of the plurality of electronic devices, wherein the gain tolerances of the plurality of electronic devices are compensated by amplifying and attenuating the signal with at least a first and a second gain compensation value in the at least two gain compensation stages, wherein the signal-amplifying component comprises a computing unit (508), the computing unit using a look-up table for determining the at least first and second gain compensation values, the look-up table comprising a plurality of temperature compensation values and/or a plurality of frequency compensation values, and wherein the computing unit transmits the first gain compensation value to the first gain compensation stage and the second gain compensation value to the second gain compensation stage.

**2.** Signal-amplifying component according to claim 1, wherein the signal-amplifying component comprises a computing unit, the computing unit calculating a temperature compensation value and/or a frequency compensation value, the computing unit determining the at least first and second gain compensation values from the temperature compensation value and/or from the frequency compensation value.

**3.** Signal-amplifying component according to any one of the preceding claims, wherein the electronic devices are cascadedly arranged.

**4.** Signal-amplifying component according to any one of the preceding claims, wherein the first gain compensation stage compensates the gain tolerances of a first subgroup of electronic devices of the plurality of electronic devices, and wherein the second gain compensation stage compensates the gain tolerances of a second subgroup of electronic devices of the plurality of electronic devices.

**5.** A receiver (512) for receiving signals, the receiver comprising a signal-amplifying component according to any one of the claims 1-4.

**6.** A transmitter (514) for transmitting signals, the transmitter comprising a signal-amplifying component according to any one of the claims 1-4.

**7.** A base station apparatus (500) in a mobile telecommunication network, the base station apparatus comprising a receiver according to claim 5 and/or a transmitter according to claim 6.

**8.** A method for compensating gain tolerances in a signal-amplifying component according to any one of the claims 1-4, the method comprising:

- Determining (S1) at least a first and a second gain compensation value, the first gain compensation value being used by the first gain compensation stage and the second gain compensation value being used by the second gain compensation stage; and

- Compensating (S2) the gain tolerances of the plurality of electronic devices by the at least first and second gain compensation stages,

wherein the step of determining the first and second gain compensation values is performed by using a look-up table, the look-up table comprising a plurality of temperature compensation values and/or a plurality of frequency compensation values.

**9.** A computer-readable storage medium containing instructions that when executed by a signal-amplifying component according to any one of the claims 1-4 cause the signal-amplifying component to perform a method for compensating gain tolerances in the signal-amplifying component, the method comprising:

determining at least a first and a second gain compensation value, the first gain compensation value being used by the first gain compensation stage and the second gain compensation value being used by the second gain compensation stage; and
- compensating the gain tolerances of the plurality of electronic devices by the at least first and second gain compensation stages,

wherein the step of determining the first and second gain compensation values is performed by using a look-up table, the look-up table comprising a plurality of temperature compensation values and/or a plurality of frequency compensation values.

**Fig. 1**

gain compensation stage 1    gain compensation stage 2    gain compensation stage 3

100 102 104 106 108 110 112 114 116 118 120 122 124 126 128 130

BTS Antenna input

| | | | Cavity Filter | | Bias-T | TMA gain | | digital step att. | | digital step att. | RF Filter | Mixer | IF Filter | digital step att. And. amp. | | LC | |
|---|---|---|---|---|---|---|---|---|---|---|---|---|---|---|---|---|---|
| | | | FE | LNA1 | DC | DSA1 | LNA2 | DSA2 | LNA3 | DSA3 | LP | Mixer | SAW | DSA | amp | Filter | ADC (150 Ohm) |
| Stage Gain | max. | | -0,8 | 22 | -0,5 | -5,3 | 17 | -16 | 17 | -12 | -0,6 | 10,5 | -10 | -6 | 23 | -0,7 | 0 |
| (dB) | typ. | | -1 | 21 | -0,5 | -5,5 | 16 | -13,5 | 16 | -9,5 | -1 | 9,5 | -11 | -4 | 22 | -1 | 0 |
| | min. | | -1,4 | 20 | -0,5 | -5,8 | 15 | -10,5 | 15 | -6 | -1,5 | 7,7 | -12 | -2 | 21 | -1,3 | 0 |
| Stage NF | max. | | 1,4 | 1,6 | 0,5 | 5,8 | 2 | 10,5 | 2 | 6 | 1,5 | 9,3 | 12 | 2 | 7 | 1,3 | 30 |
| | typ. | | 1 | 0,9 | 0,5 | 5,5 | 1,4 | 13,5 | 1,4 | 9,5 | 1 | 8,3 | 11 | 4 | 6 | 1 | 28 |
| (dB) | min. | | 0,8 | 0,8 | 0,5 | 5,3 | 1 | 16 | 1 | 12 | 0,6 | 7,3 | 10 | 6 | 5 | 0,7 | 26 |
| Input P1dB | max. | | 40 | -6 | 22 | 33 | 7,5 | 33 | 7,5 | 33 | 27 | 14,5 | 20 | 0 | -6 | 22 | 5,2 |
| (dBm) | min. | | 40 | -10 | 19 | 30 | 5,5 | 30 | 5,5 | 30 | 25 | 11 | 20 | 0 | -8 | 22 | 5,2 |
| IIP3 (dBm) | min. | | 99 | 0 | 40 | 40 | 20 | 40 | 20 | 40 | 99 | 25 | 36 | 33 | 17 | 99 | 33 |
| P1dB Margin | -- | | | 6 | 6 | 6 | 6 | 6 | 6 | 6 | 6 | 6 | 1 | | 6 | 6 | 1 |
| Level max.(dBm) | max. | | -33,1 | -11,1 | -11,6 | -16,9 | 0,1 | -15,9 | 1,1 | -10,9 | -11,5 | -1,0 | -11,0 | -17,0 | 6,0 | 5,3 | dB(m) 5,3 / mVpp 2023 / Bit 14,0 |
| | min. | | -33,7 | -13,7 | -14,2 | -20,0 | -5,0 | -15,5 | -0,5 | -6,5 | -8,0 | -0,3 | -12,3 | -14,3 | 6,7 | 5,4 | 5,4 / 2047 / 14,0 |
| Gain with FE(dB) | typ. | | -0,8 | 21,2 | 20,7 | 15,4 | 32,4 | 16,4 | 33,4 | 21,4 | 20,8 | 31,3 | 21,3 | 15,3 | 38,3 | 37,6 | 37,6 |
| Gain with FE(dB) | typ. | | -1,0 | 20,0 | 19,5 | 14,0 | 30,0 | 16,5 | 32,5 | 23,0 | 22,0 | 31,5 | 20,5 | 16,5 | 38,5 | 37,5 | 37,5 |
| Gain with FE(dB) | typ. | | -1,4 | 18,6 | 18,1 | 12,3 | 27,3 | 16,8 | 31,8 | 25,8 | 24,3 | 32,0 | 20,0 | 18,0 | 39,0 | 37,7 | 37,7 |

EP 2 362 544 A1

# Fig. 2

**Fig. 3**

Level for
max./min.
gain

dBm

10,0
5,0
0,0
-5,0
-10,0
-15,0
-20,0
-25,0
-30,0
-35,0
-40,0

Stage

0   1   2   3   4   5   6   7   8   9   10   11   12   13   14   15

max.  min.

# Fig. 4

Level for max./min. gain

dBm

20,0
10,0
0,0
-10,0
-20,0
-30,0
-40,0

Stage

0  1  2  3  4  5  6  7  8  9  10  11  12  13  14  15

— max.    — min.

# Fig. 5

500

502

504

510

508

506

100

518

100

516

514

512

520

# Fig. 6

S1

S2

Europäisches
Patentamt

European
Patent Office

Office européen
des brevets

# EUROPEAN SEARCH REPORT

Application Number

EP 10 29 0090

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/221765 A1 (SHEN YING [US] ET AL) 6 October 2005 (2005-10-06) * abstract; claim 1; figures 1, 4-6 * * paragraphs [0008], [0032] - [0041], [0060] - [0068], [0071] - [1122] * ----- | 1-15 | INV. H03G3/30 |
| X | WO 01/11769 A1 (HARRIS CORP [US]) 15 February 2001 (2001-02-15) * abstract; figures 1-4 * * page 2, line 7 - page 4, line 8 * * page 6, line 3 - page 8, line 2 * ----- | 1-6,8-15 | |
| X | US 7 088 975 B1 (GOMEZ RAMON A [US] ET AL) 8 August 2006 (2006-08-08) * figures 1-3 * * column 2, lines 13-50 * * column 4, lines 7-26 * * column 8, lines 20-30 * ----- | 1,4,7,8, 11,14 | |
| A | US 2008/293369 A1 (DVORSZKY ROBERT [DE] ET AL) 27 November 2008 (2008-11-27) * abstract; figures 2,3 * * paragraphs [0005] - [0008], [0014] - [0029] * ----- | 1-15 | TECHNICAL FIELDS SEARCHED (IPC) H03G H04B |

The present search report has been drawn up for all claims

| Place of search | Date of completion of the search | Examiner |
|---|---|---|
| Munich | 29 July 2010 | Wichert, Beate |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 10 29 0090

This annex lists the patent family members relating to the patent documents cited in the above-mentioned European search report.
The members are as contained in the European Patent Office EDP file on
The European Patent Office is in no way liable for these particulars which are merely given for the purpose of information.

29-07-2010

| Patent document cited in search report | | | Publication date | Patent family member(s) | | | Publication date |
|---|---|---|---|---|---|---|---|
| US 2005221765 | A1 | | 06-10-2005 | US WO | 2009017774 2005099111 | A1 A1 | 15-01-2009 20-10-2005 |
| WO 0111769 | A1 | | 15-02-2001 | AT AU DE DE EP US | 232661 6755800 60001426 60001426 1206834 6418301 | T A D1 T2 A1 B1 | 15-02-2003 05-03-2001 20-03-2003 25-09-2003 22-05-2002 09-07-2002 |
| US 7088975 | B1 | | 08-08-2006 | NONE | | | |
| US 2008293369 | A1 | | 27-11-2008 | DE EP JP | 102007024013 2001129 2008295050 | B3 A2 A | 27-11-2008 10-12-2008 04-12-2008 |

EPO FORM P0459

For more details about this annex : see Official Journal of the European Patent Office, No. 12/82

**EP 2 362 544 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1418676 A1